(19) Europäisches Patentamt
European Patent Office
Office européen des brevets

(11) **EP 4 235 197 A1**

(12) **EUROPEAN PATENT APPLICATION**

(43) Date of publication:
**30.08.2023 Bulletin 2023/35**

(21) Application number: **22158578.9**

(22) Date of filing: **24.02.2022**

(51) International Patent Classification (IPC):
**G01R 31/34** (2020.01)      **G01R 23/18** (2006.01)

(52) Cooperative Patent Classification (CPC):
**G01R 31/343**; G01R 23/18

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Hitachi, Ltd.**
**Tokyo 100-8280 (JP)**

(72) Inventors:
• **KATO, Tetsuji**
**London, EC2Y (GB)**
• **YAMASHITA, Tomoaki**
**London, EC2Y (GB)**

• **KILSBY, Paul**
**London, EC2Y (GB)**
• **UEMURA, Takuya**
**Tokyo, 100-8280 (JP)**
• **ENOKIDA, Kouichi**
**Tokyo, 100-8280 (JP)**
• **HAYASHI, Gousuke**
**Tokyo, 100-8280 (JP)**
• **DEGUCHI, Kenta**
**Tokyo, 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **METHOD AND SYSTEM FOR DIAGNOSING A MACHINE**

(57)      Method for determining the slip of a machine which comprises the steps of: receiving a measurement signal, wherein the measurement signal includes a set of measurement values of an operational parameter of the machine; determining the frequency spectrum of the measurement signal by converting the measurement signal into the frequency domain; determining whether the frequency spectrum includes at least two peaks in the frequency spectrum for which different types of failure mode calculations return the same slip value; wherein, if in the determining step it is found that two peaks exist in the frequency spectrum which return the same slip value, said value is determined to be the slip value of the machine.

Fig. 2

EP 4 235 197 A1

## Description

The present disclosure relates to the field of machine diagnosis and failure prediction of machines. In particular, in the present disclosure, the diagnosis relates to reliably determining a rotational speed or the slip of a machine, which is preferably a rotatory machine, especially a motor, and very preferably an induction type motor. Based on the herein described accurate determination of the slip, a defect or a failure of a machine can be predicted reliably. In other words, knowing the slip value enables to determine the status of a machine or a machine part more reliably. Machine parts may include one or more bearings, axles, shafts, housings and the like.

## Background

Mechanical defects of a machine can lead to a fatal failure and, thus, they can endanger the operation safety and the uptime of a machine. Therefore it is important to reliably detect a degradation or defects of a machine; preferably well before the defect or the degradation causes a fatal failure of the machine.

Consequently, it is desirable that signs of a machine failure are detected with high accuracy and well before a defect or a degradation could lead to a fatal failure in order to avoid them.

In connection with the diagnosis of machines, especially in regard of motors, the motor current signature analysis (MCSA) is already known. Based on MCSA, certain frequencies or peaks at certain frequencies in a frequency spectrum are used as an indicator for different types of defects or failures. For example, an abnormal rotation of the motor may be indicated by a characteristic frequency component $F_{char}$ of the phase current which is defined by equation (1) below:

$$Fchar = f \pm \left(\frac{f}{P}\right) * (1 - s) \text{ (eq. 1).}$$

In equation (1), which indicates a particular defect/failure mode, f is the fundamental frequency of the motor current, P is the number of pole pairs of the motor, and s is the slip ratio (or "slip") of the motor. While f and P are usually known, an exact value of s is usually not known. The missing information about the value of the slip has the consequence that the accuracy of a failure or defect sign detection is reduced.

Further, the signal level of Fchar is expectably comparable to the noise level in the frequency spectrum and, moreover, the frequency spectrum further includes peaks which are not connected to a failure or defect. Both renders it difficult to read a value for the slip directly from the frequency spectrum. However, with the slip being unknown or not accurately determined, a defect or failure prediction is difficult and potentially not accurate, as mentioned above.

Therefore, in order to enable an increase in regard of the accuracy of the diagnosis of a machine, it is desirable to identify the slip value of the machine with high accuracy. In this connection, there are concepts which are already known, i.e. for determining the slip, and which are based on searching a maximum peak value in a reduced range of the frequency spectrum. The concept assumes that the maximum peak represents a characteristic frequency of a certain defect and that this allows to determine the slip. This concept, however, has the problem that the peak can be quite small and that it can be overlapped by noise. Identifying the "right" peak, hence, is difficult and error-prone. The same difficulties are common with other known concepts according to which the harmonics of frequency signals are analyzed because they are even smaller.

Summarizing, it is desirable to enable an improvement of the diagnosis of a machine, especially by improving the determination of the slip value.

## Problem and Solution

It is an object of the herein described disclosure to provide, at least, a method, a device and a computer program product which enable a more accurate determination, at least, of the slip of a machine while avoiding a computationally complex processing.

The following aspects are in particular provided: According to a first aspect, there is provided: A method for determining the slip of a machine. Preferably, the machine is a motor and very preferably the machine is an induction type motor.

The method may comprise a number of steps for determining and optionally outputting the value of the slip, i.e. the slip value. The outputting may include outputting the value to a user via a display and/or the outputting may include sending the determined slip value to another entity or apparatus which may use the determined slip value for further processing. For example, the other apparatus may be a diagnostic device for a machine to diagnose failures or defects based on the determined slip value or the other entity may be another part of the diagnostic device in case that the herein described method is performed within the diagnostic device. Outputting in connection with the latter may also encompass that, besides sending the data relating to the slip value via a data connection, the value of the slip is stored in a database and another apparatus or another entity of the same apparatus reads the value from the database.

The method steps preferably include: Receiving a measurement signal, wherein the measurement signal includes one or more sets of measurement values of an operational parameter of the machine; determining the frequency spectrum of the measurement signal by converting the measurement signal into the frequency domain; determining whether the frequency spectrum includes at least two peaks (frequency values thereof) in the frequency spectrum for which different types of failure mode calculations return the same slip value, and/or outputting the determined slip value. The latter step may also alternatively and/or additionally include/replaced by that said value is determined to be the slip value of the machine, if the determining step has found that two peaks exist in the frequency spectrum which return the same slip value.

The measurement signal may be received from one or more sensors which record/measure/sense the measurement values of the operational parameter over time, and the measurement signal is a set of the measurements values between two points in time, i.e. a start time and an end time. The two time points may be defined or set by the user; or predefined time schedules may be set during which measurement values are recorded. Further, instead of receiving the measurement signal from one or more sensors directly (or via a data logging device or the like), the measurement signal may be read from a database in which the measurement values of the sensor(s) (or any other device) are stored. In regard of directly using sensor (and/or other devices) measurement values/data, a machine can be diagnosed at the present moment. Reading database data allows diagnosing a machine at any point of time after the operation of the machine, so that diagnosis can be scheduled conveniently.

Further, determining the frequency spectrum of the measurement signal by converting the measurement signal into the frequency domain can be performed by any known method which allows to transform the time-based measurement signal into a frequency spectrum in the frequency domain; one possible example may be the use of the Fast Fourier Transform (FFT).

Further, the step of determining whether the frequency spectrum includes at least two peaks in the frequency spectrum, for which different types of failure mode calculations return the same slip value, provides the slip value for which it is searched.

A "peak" or "frequency peak" in the frequency spectrum shall be understood, preferably, to relate to a single amplitude value at a local or global maximum or to a distribution of amplitude values around a local or global maximum. The peak is related to a frequency component of the frequency spectrum. With each input/received measurement signal converted into the frequency domain, the converted measurement signal will include a plurality of frequency components, wherein the term "frequency component" of the frequency spectrum shall indicate the amplitude value at a discrete frequency value. For example, if the measurement signal transformed to the frequency domain will cover a range from 0 Hz to 100 Hz, each of the frequency values between (including the edges) 0 Hz and 100 Hz will exhibit a related amplitude value (y-axis value if the frequency is on the x-axis) which may take any value which may also be zero. Hence, if the operational parameter is an electric current, the amplitude value at a specific frequency component will be the value of the electric current in Ampere at said frequency value.

The failure mode(s) shall preferably relate to specific errors/failures/defects etc. of the machine and it shall be preferably described by an equation which indicates a characteristic frequency of the specific error. For example, equation (1) above describes the characteristic frequency $F_{char}$ for the failure mode describing an abnormal rotation of the motor. For the calculations of this step, the frequency values of the frequency components/peaks are inserted for "$F_{char}$" and the equation can be solved for the slip which returns a slip value. For the calculations, further, a second failure mode, defined by another equation, is used and "pairs" of peaks/frequency components can be identified when the two different equations return an identical slip value for different peaks/frequency components. If a pair is found, the corresponding slip value is determined as the slip value which is the slip value of the machine. The determination may also return "true" if such a pair of peaks has been found, i.e. when a slip value has been determined, and said value of the slip for which "true" has been returned can be output.

The calculation process for determining the slip value is preferably performed repeatedly until the calculations have been performed for all peaks or for all peaks of a sub-group of peaks.

It is possible that the frequency spectrum is displayed to a user by a display unit and that the user marks/selects (all) frequency components/peaks or just a subgroup of the frequency components for the further processing. Alternatively or additionally, an analyzing unit or another unit of a diagnostic device or of a (remote) computer system may perform the task of selecting one or more or all frequency components of the spectrum for the determination step. Very preferably, a machine learning logic (ML) or an artificial intelligence (AI) has been trained for the task of identifying and selecting peaks and the trained ML/AI can be used for performing said task. Furthermore, alternatively or additionally to the above, the frequency components/peaks may be selected based on a predefined regime which most preferably makes us of a (pre-)set step distance, which has a frequency value. For example the step distance may be set by a user, an AI/ML or it may be prestored/preset in a memory. Based on said step distance, frequency components may be selected, wherein a frequency component may be selected if it equals a multiple of the step distance, which is given in Hertz. Preferably, the first frequency component that may be selected is the edge of the frequency range covered by the measurement signal in the frequency domain. For example, if the step distance is preset to be 0.1 Hz and if the spectrum would start at 0 Hz, every amplitude value at 0 Hz, 0.1 Hz, 0.2 Hz and so on would be selected. If the step distance has a different value than 0.1 Hz in the above example, the selection would proceed analogously. An upper value for the frequency components to be selected may be (pre-)set. Even further, the selection may further take into account that only frequency components are selected which represent a "peak" in the sense of being a local or global maximum.

Most preferably, the selection of peaks, i.e. the frequency values thereof which shall be inserted into the (at least two different) failure mode equations, is performed by a ML or AI which has been trained with relevant frequency spectra as an input to output a selection of peaks of a spectrum. Otherwise, the selection may also be performed by a user manually or by a computer according to a predefined selection algorithm.

The determination of the slip value is performed with high accuracy because, inter alia, the negative influence of noise and of other signal artefacts is reduced or even suppressed. The determination, further, is not related to increased computational burden or complexity because of the relatively low number of processing steps which are, moreover, mathematically/computationally not complex.

According to a preferred further aspect, the step of determining the slip value, including the failure mode calculation, makes use of different, at least two, equations which describe a characteristic frequency component of a failure mode.

According to a preferred further aspect, a first equation used for the failure mode calculations is the characteristic frequency of a broken rotor bar of a motor, and a second equation is the characteristic frequency of an abnormal rotation of the motor.

The equation for the abnormal rotation is given above as equation (1). The broken rotor bar is represented by

$$Fchar = f \pm 2s\left(\frac{f}{P}\right) \text{ (equation (2))}.$$

.

Other failure modes and respective equations of the corresponding characteristic frequency may be used instead and the above two equations (1) and (2) represent merely one possible pair usable for the claimed method. Further, if the machine is not a motor, other equations may be used, too. For example, other error modes may relate to a static eccentricity of the rotor, a dynamic eccentricity of the rotor, a stator iron core damage, loose windings, a short circuit of windings, a bearing deterioration (ball, outer rotor, etc.), and other machines may include a gear, a generator, a load equipment connected to motor, or the like.

Using analytic equations which output a clear computational result increases accuracy over prior art methods which try to identify values by visually inspecting frequency spectra or the like and which may be influenced by noise and other artefacts.

According to a preferred further aspect, the failure mode calculations are performed by inserting the frequency values of peaks or frequency components read from the frequency spectrum into the different equations and by solving the equations for the value of the slip. The number of equations preferably matches the number of frequency values, and very preferably two frequency values of two peaks/frequency components are inserted into two different failure mode equations. This is repeated until the selected peaks are processed entirely or until at least one pair of frequency values is detected which returns an identical slip value.

This way of processing returns the correct machine slip and computationally it merely requires to solve two (analytically solvable) equations for a limited number of frequency components/peaks. The comparison clearly identifies whether a read peak relates to noise or an artefact, or not.

According to a preferred further aspect, the method includes a further step of reducing the number of peaks/frequency components in the frequency spectrum before the determination step is performed, wherein the reducing of peaks is performed by omitting, i.e. deselecting or not selecting, peaks which are not symmetric around the fundamental frequency peak of the machine.

In order to reduce the number of processing steps even further, hence the computational burden, the frequency spectrum or a list of peaks to be processed may be cleared from frequency components/peaks which can be excluded to correspond to a failure mode. As equations (1) and (2), e.g., show, the characteristic frequencies of one failure mode are positioned with one peak at the left (lower frequency values) and with another peak at the right (higher frequency values) compared to the fundamental frequency of the machine, which is clear from the equations having a $\pm$ - term. Based on this, peaks which are not symmetric around the fundamental frequency can be omitted, e.g., because they are caused by noise or other reasons.

According to a preferred further aspect, peaks which relate to a folding frequency peak are not omitted.

If a slight drop of accuracy shall be avoided, in view of the above described omitting of non-symmetric peaks, folding may be considered. In other words, folding-related frequency components/peaks may be maintained, i.e. not omitted.

According to a preferred further aspect, the method includes a further step of reducing the frequency range to be searched for peaks by setting a predetermined range of slip values. The reduction of the frequency range may preferably include that one or more subranges of the entire frequency spectrum are defined as ranges to be searched. For example, if the predetermined range of slip values should be set, preferably, to a range of values up to 0.05 or up to 0.1, two relatively narrow frequency ranges around the fundamental frequency will be returned as the frequency ranges to be searched. All other frequencies (peaks/components) will not be processed, which further reduces the computational complexity and burden. As noted, preferable ranges for the slip values may be set between 0 or a small value unequal 0, such as 0.001, 0.005 or 0.01, and a value of 0.5, 0.1 or even more than 0.1, such as 0.15 or 0.2.

According to a preferred further aspect, the operational parameter is a phase current of the machine measured overtime.

According to a preferred further aspect, the operational parameter is a torque current of the machine measured overtime.

The above options allow different measurement and post-measurement techniques and thus provide flexibility in view of the equipment used for measuring the measurement values.

According to a preferred further aspect, if more than one pair of peaks is determined during the determination step, a (post-processing) step is carried out before outputting the slip value and the slip value is selected according to a predefined requirement or schedule or criterion. The predefined requirement or criterion may include selecting the frequency components corresponding to the maximum slip value or which have the highest peak in the frequency spectrum or the like.

Hence, even if more than one candidate for the slip value is returned, a slip value can be accurately determined, e.g., based on the very preferred criterion of the maximum slip value which can be identified with low burden.

According to a preferred further aspect, the step of determination is carried out for the upper values of the characteristic frequency of the failure mode.

Upper values shall be understood as the values which have a frequency value higher than the fundamental frequency component. The technical benefit is that these peaks/frequency components are less affected by noise.

According to a preferred further aspect, in addition or alternatively, the speed is output based on the determined slip value. Slip is defined as the difference between synchronous speed and operating speed of a rotating machine, such as a motor, at the same frequency, expressed in rpm, or in percentage or ratio of synchronous speed. Thus, for an electric motor the slip can be expressed as [(speed of the stator electrical speed minus mechanical speed) divided by speed of the stator electrical speed].

The method can thus be used, at the same time or exclusively, for a rotational speed determination of the machine.

A further aspect may relate to a device for performing the method of at least one of the previous method aspects, having an input unit for receiving a measurement signal, wherein the measurement signal includes a set of measurement values of an operational parameter of the machine, a computing unit for performing the methods steps including determining the frequency spectrum of the measurement signal by converting the measurement signal into the frequency domain, and determining whether the frequency spectrum includes at least two peaks in the frequency spectrum for which different types of failure mode calculations return the same slip value, and an output unit for outputting the determined slip value.

Further, a system may be provided with includes the above device and further components, devices and the like, including one or more machines, sensor(s), PLC device(s), storage device(s) and/or personal computing devices.

A further aspect may relate to a computer program product having computer program logic arranged to put into effect the method aspects as described above when being executed by a computer.

All aspects and preferred options synergistically enable, at least, to provide a more accurate determination of the slip of a machine while avoiding a computationally complex processing.

**Brief Description of Drawings**

Fig. 1     shows a schematic example of a frequency spectrum, as analyzed by the present disclosure.

Fig. 2     shows a schematic of a system including a device for performing a method as disclosed.

Fig. 3     shows a flow chart of method steps of the present disclosure.

Fig. 4     shows one step of the disclosed method performed on an exemplary frequency spectrum.

Fig. 5     shows one step of the disclosed method performed on an exemplary frequency spectrum.

Fig. 6     shows one step of the disclosed method performed on an exemplary frequency spectrum.

Fig. 7     shows one step of the disclosed method performed on an exemplary frequency spectrum.

Fig. 8     shows another flow chart of method steps of the present disclosure according to a modified method.

Fig. 9     shows a schematic of another system including a device for performing a method as disclosed.

Fig. 10    shows another schematic example of a frequency spectrum, as analyzed by the present disclosure.

**Detailed Description**

In the following, preferred aspects and examples will be described in more detail with reference to the accompanying figures. Same or similar features in different drawings and examples are referred to by similar reference numerals. It is to be understood that the detailed description below relating to various preferred aspects and preferred examples are not to be meant as limiting the scope of the present disclosure.

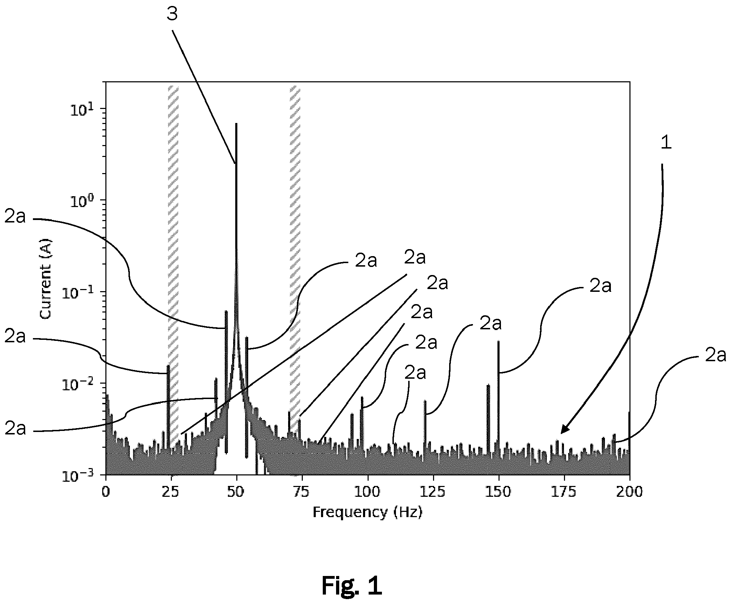

Figure 1 shows a frequency spectrum 1 which has been generated from one or more time-based measurement signals (not shown). The frequency is provided on the X-axis and the measurement value, preferably the electric current of a phase of the machine in Ampere, which is preferably an electric motor 10, is provided on the Y-axis. The frequency spectrum 1 has been generated by transforming the measurement signal(s) from the time-domain into the frequency-domain, e.g. by the use of FFT or another suitable method.

As one can further see, the largest peak in the frequency spectrum 1, as shown by Figure 1, is located at 50 Hz which is the fundamental frequency component 3 of the machine, i.e. a motor 10 in the present example. Furthermore, a plurality of further peaks 2a can be identified from the example of Figure 1, wherein a peak 2a shall be preferably understood as a maximum (preferably a local maximum). The number of indicated peaks 2a in Figure 1 is not representative and the number of reference signs indicating a peak 2a has been reduced for reasons of readability of Figure 1.

Further, Figure 1 includes two shaded areas at around 25 Hz and above and at around 75 Hz and below. These frequency ranges are indicated as an example for a possible reduced search range of peaks 2a in case that the herein described method is applied to a reduced range of slip values. The reduced range of slip values "s" can range from 0 to 0.1, as in the example of Figure 1. The hatched/shaded areas of Figure 1 result from applying equation (1), see above, with the range of predetermined slip values "s" = 0..0.1, with a fundamental frequency component "f" of 50 Hz and with "P", as the number of pole pairs, set to 2.

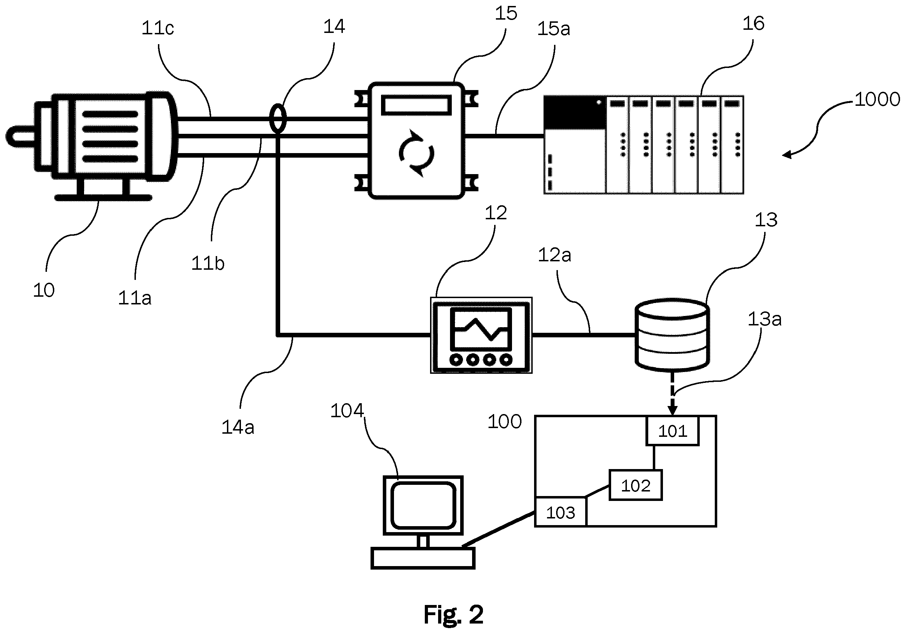

Figure 2 shows a system 1000 which includes the machine, e.g. a motor 10, which shall be analyzed or diagnosed by the herein disclosed method, device and/or computer program product. The motor 10 is connected to three electrical lines for three electrical phases, as indicated by 11a, 11b and 11c. A current sensor 14 is provided at least at one electrical line for measuring the electrical current over time. In the present example, the line indicated by reference sign 11c is sensed by the current sensor 14. All other phases may be used as well. The current sensor 14 may be provided at any location between the motor 10 and an inverter 15 which is electrically connected to the motor 10. The current sensor 14 is connected via connection 14a to a data logger 12 or any other suitable unit for sampling one or more measurement signals in the time domain (not shown). The data signals generated by the current sensor 14 are transferred to the data logger 12 via the respective connection 14a. The data generated by the data logger 12 may be passed/transferred via connection 12a to a database 13 for temporary and/or permanent storage. The database 13 may be part of the device 100 (a diagnosis device) or it may be outside of the device 100. The device 100 may be provided at the location of the motor 10 or it may be located at a remote place, which is indicated by the broken arrow 13a. The device 100 itself mainly includes an input unit 101, an output unit 103 that may be connected to a personal computer 104 or any other suitable device with which a user may access the diagnosis data, and a computing unit 102. The computing unit 102 may also be named "analyzing unit" or "diagnosis unit" and it preferably includes (or is connected to) one or more processors, internal memory and the like, such as an ASIC, a CPU and the like. The internal memory, e.g., may store the computer program product for performing the method as disclosed herein.

The Figure 2 further shows that the inverter 15 is connected via line 15a with a programmable logic controller (PLC) 16 which may be provided in the system 1000, as shown in Figure 2. The PLC 16 may be provided for performing the control of the machine/motor 10 operation. It is possible, as a variation that is not shown in the Figures, that the device 100 (including subunits 101 through 104 and possibly 13) is integrated into the PLC 16 so that the current sensor 14 would feed the measurement data thereto.

The depicted data connections or lines may be wireless or wire-based electrical connections.

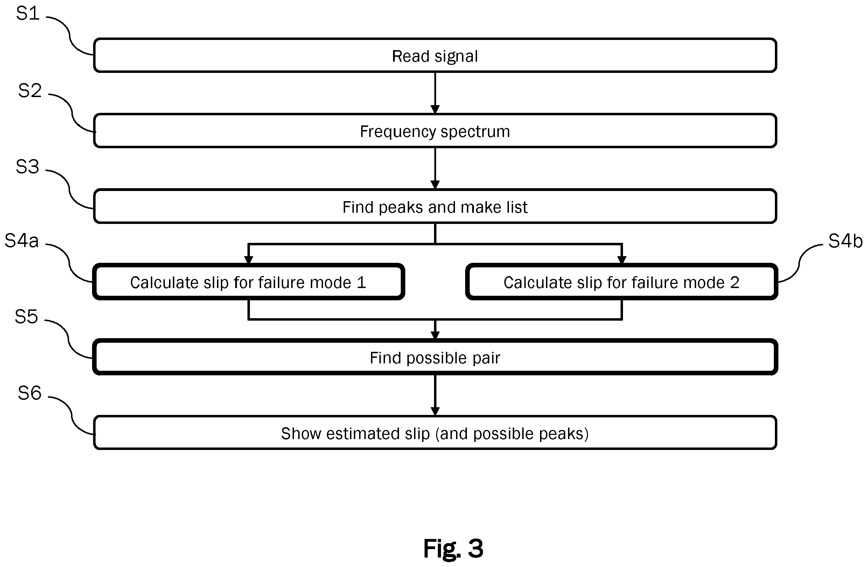

Figure 3 shows a first example of a method according to a preferred process flow. A first step, S1, includes reading the measurement signal from the database 13 or directly from the current sensor 14. This is followed by step S2 during which the transformation into the frequency domain of said measurement signal is performed according to known methods. Both steps can be performed by the computing unit 102 or by the data logger 12, by an internal computing unit of the current sensor 14 or any other suitable unit. Preferably, the steps S1 and S2 are performed based on data stored in the database 13 and in the device 100. This also holds for the further steps which are preferably performed by the device 100 which may be separated from the PLC 16 or integrated therein.

The next step, S3, is the search for peaks 2a in the frequency spectrum 1 and, preferably, a list of identified peaks 2a is generated. However, instead of a list, any other format is possible for at least temporarily storing the peaks 2a which have been identified from the frequency spectrum 1. Each peak 2a identified is then used for finding a pair of at least two peaks 2a which have the same slip value for different failure modes. In other words, step 4 includes two sub-steps, S4a and S4b, in which the identified peaks 2a, i.e. the frequency values thereof, are used to calculate the slip value for two different failure modes and to compare the calculated results to determine whether they match.

The preferred failure modes are described by the above introduced equations (1) and (2), so that, e.g., in step S4a equation (1) is used and in step S4b equation (2) is used for two different identified peaks 2a, i.e. frequency values thereof. For steps S4a and S4b it is assumed that the only unknown variable in the equations is "s". For example, it may be assumed that a motor 10 is used that has f = 50 Hz and P = 2.

If a same slip value is found during the repeated performing of steps S4a and S4b, the associated peaks/frequency values form a possible pair, which is identified in step S5. The calculations according to steps S4a and S4b are carried out for all identified peaks 2a, i.e. as long as no identified peak 2a has not been processed.

Further, optionally, the estimated/calculated slip value and the peaks 2a associated thereto, may be shown (S6) to a user on the computer 104 and/or the results may be output to another device or entity for a further processing, e.g., the slip value may also be input to the PLC 16 in order to use this value for the control of the machine or the like.

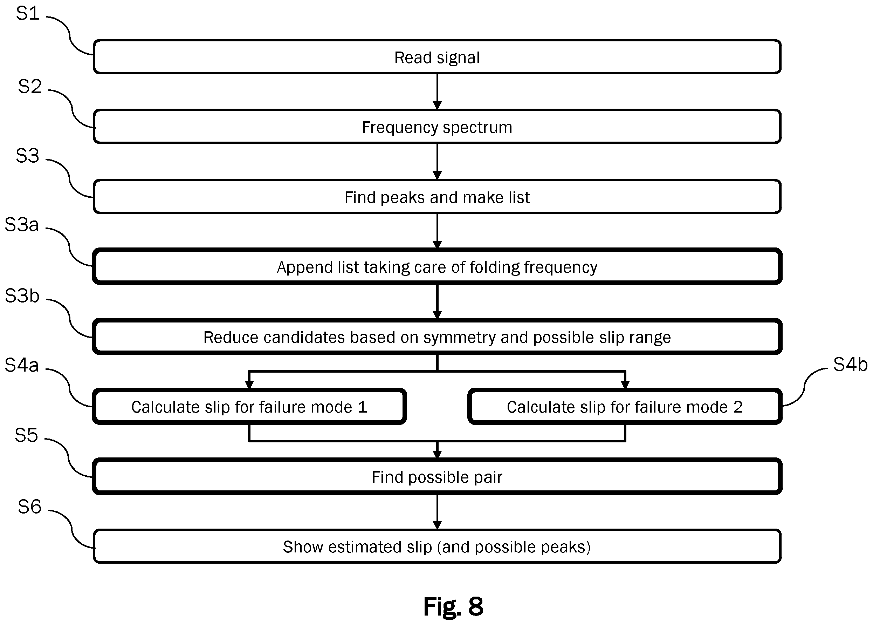

Furthermore, according to a modification, Figure 8 shows the method with further steps S3a and S3b according to which the frequency spectrum 1 is pre-processed in order to reduce the number of peaks 2a which are processed in steps S4a and S4b. It is possible that only one of the steps S3a and S3b is used in a modified method or, preferably, both are used in a modified method. Step S3a includes the process of finding folding frequencies, wherein the identification is carried out as known in the art. Folding frequencies or frequency components relating to folding are maintained in the frequency spectrum 1 according to Step S3a. Further, Step S3b includes the omission of peaks 2a from the frequency spectrum 1 based on two options which may both be used or one of them. The first option is to identify all peaks 2a which do not have a counterpart symmetrically arranged to the fundamental frequency (50 Hz in the present example of Figure 2) and to omit these non-symmetric peaks 2a; except those which are related to folding. The second option may include to reduce the number of peaks 2a processed in the steps S4a and S4b by narrowing the frequency range(s) to be searched for peaks by predetermined allowable slip values/range, such as 0 to 0.1 or 0 to 0.05 or 0.01 to 0.1, or the like. The latter is indicated in Figure 2 by hatching with a slip range of 0 to 0.1 and when applying the equation (1) for a motor with f = 50 Hz and P = 2.

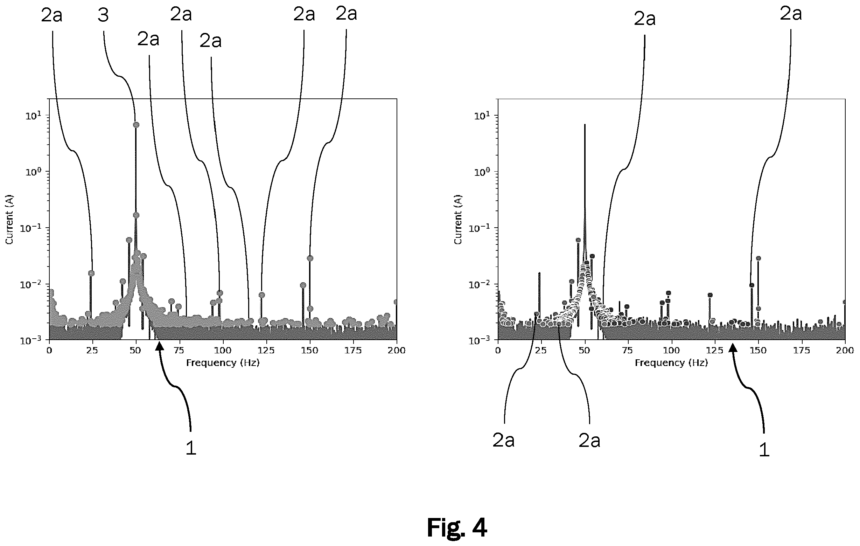

Figure 4 shows an example of the process for identifying peaks 2a in the frequency spectrum 1 and each identified peak 2a is symbolized by a full dot (light grey) at the top of the peak. As one can see in the left part of Figure 4, the number of peaks 2a identified is expectably quite high. Therefore, the process of omitting some peaks 2a, yields a preselection of peaks 2a (full dots at the selected peaks) to be further processed. Omitting non-symmetric peaks 2a, e.g., considerably reduces the number of peaks 2a and the result of an example is shown in the right-hand side frequency spectrum of Figure 4. Again, it is noted that the references numbers "2a" are provided only for few peaks in order to maintain the readability of the graphs/Figures.

The identification of peaks 2a and the selection for further processing, as well as the omission of peaks 2a, can be done manually by a user and/or can be performed in an automated manner. The automation may use a computer which includes respectively configured algorithms and programs and very preferably an AI or ML unit trained for the tasks may be used. The training data may include frequency spectrum data.

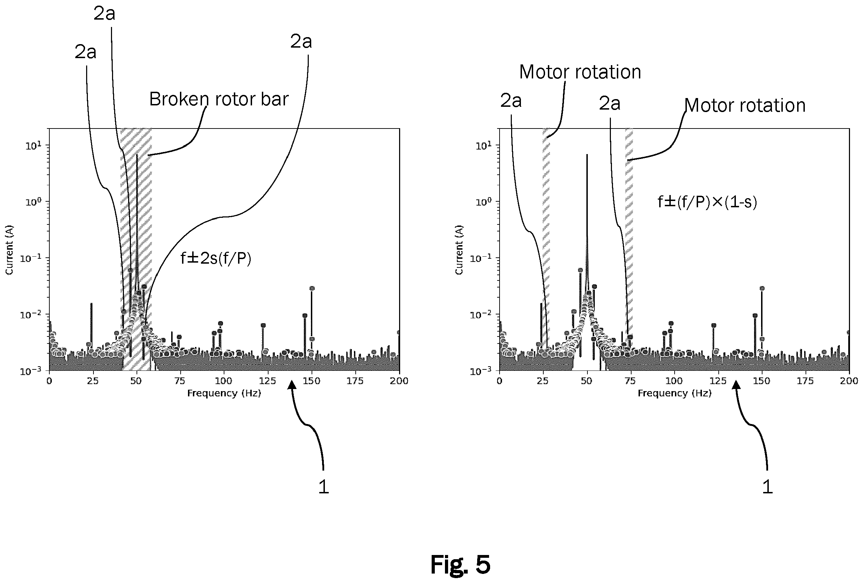

In addition to the omission of non-symmetric peaks 2a, which may be associated to noise, e.g., it is further possible, as described in the second option above and as shown by Figure 5, to further reduce the number of processed peaks 2a by reducing the allowable range of slip values. Figure 5 shows on the left-hand side the frequency range (hatched) in which peaks 2a are identified and processed if the step S4a/S4b uses the failure mode of a broken rotor bar of a motor 10. The equation (2) used for this failure mode returns possible values around 50 Hz in Figure 5 and the hatched area indicates slip values from 0 to 0.1. The ranges in case of an abnormal motor rotation are shown in the right-hand side frequency spectrum of Figure 5, also for slip values from 0 to 0.1. The ranges result from applying equation (1) as explained above with f = 50 Hz and P = 2. Again, it is noted that the references numbers "2a" are provided only for few peaks in order to maintain the readability of the graphs/Figures, while the graphs of Figure 5 include more pre-selected peaks 2a as indicated by the full dots on the top of each peak 2a/3.

As one can see, the application of ranges for allowable predetermined slip values/ranges considerably reduces the number of peaks 2a which have to be processed in the steps S4a and S4b.

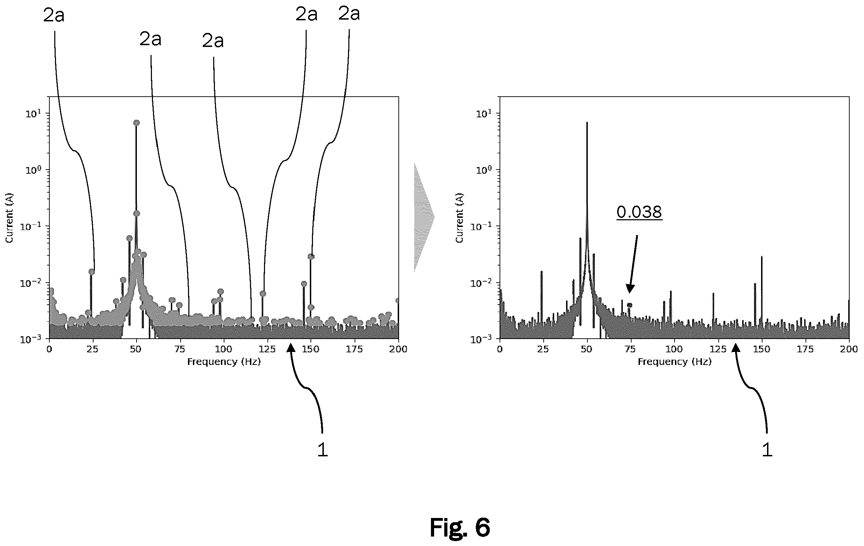

Figure 6 shows an example of the result of the processing and the output thereof in step S6. The left-hand side frequency spectrum 1 shows the identified peaks 2a by light grey full dots on each peak; in this example case no omission or preselection is performed. Again, it is noted that the references numbers "2a" are provided only for few peaks in order to maintain the readability of the graphs/Figures, while the graphs of Figure 5 include more pre-selected peaks as indicated by the full dots on the top of each peak 2a/3. The right-hand side frequency spectrum 1 of Figure 6 shows a possible output screen to a user which includes the slip value calculated to be s = 0.038. In this example the peak 2a is indicated which belongs to this slip value. Of course, the output to the user may be arranged differently or, instead or in addition, the slip value may be passed to a further entity, e.g., for an improved motor control or the like.

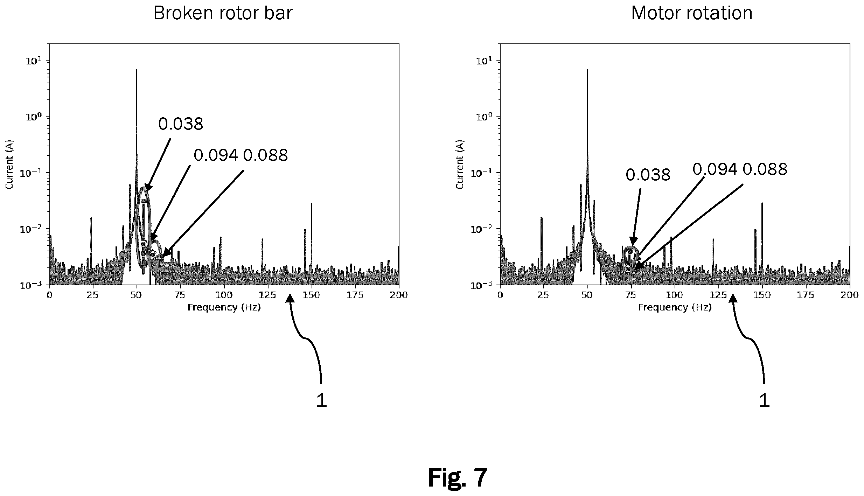

Figure 7 with the frequency spectra 1 on the left- and right-hand side shows the situation that the two different failure modes (left broken rotor bar) and right (abnormal rotation) return more than one possible value for the slip. Here, e.g., 0.038, 0.088 and 0.094. In this case, a processing may be performed by the device 100 and, e.g., the largest or lowest slip value may be selected according to a predefined criterion. Further, as shown in the example of Figure 7, the slip value corresponding to the highest peaks is selectable, which is s = 0.038 in this example.

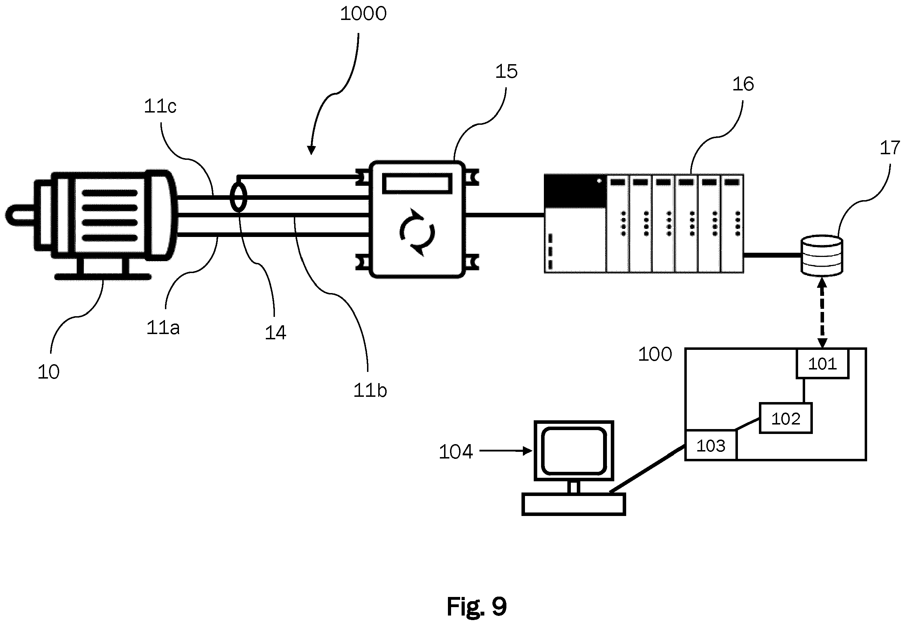

Figure 9 shows another example system 1000 according to which, different to the example of Figure 2, the torque current is used instead of the phase current for the processing as described above. In this case, the current sensor 14 feeds the measurement signals/data/values into the inverter 15 and/or to the PLC 16. The PLC 16 may include the database 17 or may send the data to an external database 17, which may also be integrated into the device 100. The device 100 may be remote or placed locally, and it may perform the same method steps as described before with the measurement signal received or read from the database 17. The difference with regard to the torque current is that no folding frequencies are present and therefore, the method steps according to Figure 3 are preferred. The additional effort of reducing peaks 2a can be avoided.

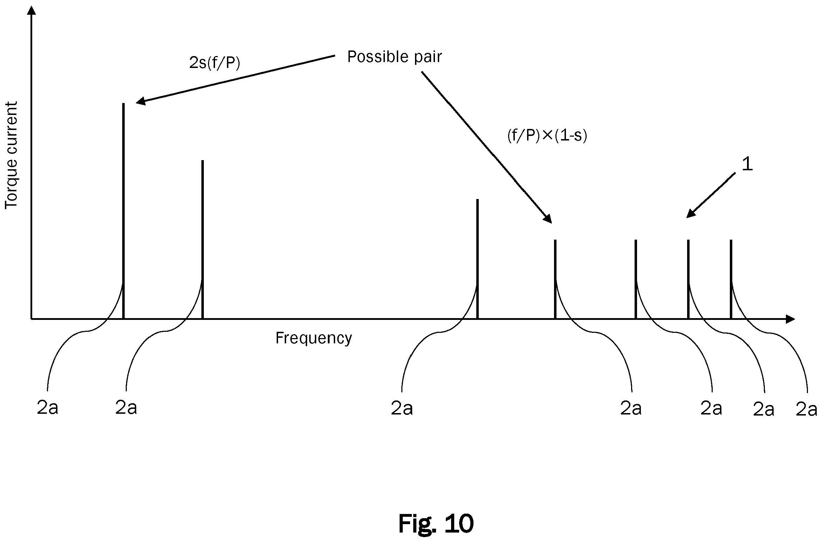

Figure 10 further shows a very schematic example of a frequency spectrum 1 generated from a torque current measurement signal and a possible pair of two peaks 2a returning the same value for the slip are indicated in this Figure.

The determination of the slip value according to the present application is performed with high accuracy because, inter alia, the negative influence of noise and of other signal artefacts is reduced or even suppressed. The determination, further, is not related to increased computational burden or complexity because of the relatively low number of processing steps which are, moreover, mathematically/computationally not complex.

As will be appreciated by one of skill in the art, the present disclosure, as described hereinabove and the accompanying figures, may be embodied as a method (e.g., a computer-implemented process or any other process), apparatus (including a device, machine, system, computer program product, and/or any other apparatus), or a combination of the foregoing. Aspects/Examples of the present disclosure may be a software entirely (including firmware, resident software, micro-code, etc.), or a combination of software and hardware aspects that may be referred to as a "system". Furthermore, the present disclosure may take the form of a computer program product on a computer-readable medium having computer-executable program code embodied in the medium.

It should be noted that arrows may be used in drawings to represent communication, transfer, or other activity involving two or more entities. Double-ended arrows generally indicate that activity may occur in both directions (e.g., a command/request in one direction with a corresponding reply back in the other direction, or peer-to-peer communications initiated by either entity), although in some situations, activity may not necessarily occur in both directions.

Single-ended arrows generally indicate activity exclusively or predominantly in one direction, although it should be noted that, in certain situations, such directional activity actually may involve activities in both directions (e.g., a message from a sender to a receiver and an acknowledgement back from the receiver to the sender, or establishment of a connection prior to a transfer and termination of the connection following the transfer). Thus, the type of arrow used in a particular drawing to represent a particular activity is exemplary and should not be seen as limiting.

The present disclosure may be described with reference to flowchart illustrations and/or block diagrams of methods and apparatuses, and with reference to a number of sample views of a graphical user interface generated by the methods and/or apparatuses. It will be understood that each block of the flowchart illustrations and/or block diagrams, and/or combinations of blocks in the flowchart illustrations and/or block diagrams, as well as the graphical user interface, can be implemented by computer-executable program code.

The computer-executable program code may be provided to a processor of a general purpose computer, special purpose computer, or other programmable data processing apparatus to produce a particular machine, such that the program code, which executes via the processor of the computer or other programmable data processing apparatus, create means for implementing the functions/acts/outputs specified in the flowchart, block diagram block or blocks, figures, and/or written description.

The computer-executable program code may also be stored in a computer-readable memory that can direct a computer or other programmable data processing apparatus to function in a particular manner, such that the program code stored in the computer readable memory produce an article of manufacture including instruction means which implement the function/act/output specified in the flowchart, block diagram block(s), figures, and/or written description.

The computer-executable program code may also be loaded onto a computer or other programmable data processing apparatus to cause a series of operational steps to be performed on the computer or other programmable apparatus to produce a computer-implemented process such that the program code which executes on the computer or other programmable apparatus provides steps for implementing the functions/acts/outputs specified in the flowchart, block diagram block(s), figures, and/or written description. Alternatively, computer program implemented steps or acts may be combined with operator or human implemented steps or acts in order to carry out an embodiment of the disclosure.

It should be noted that terms such as "server" and "processor" may be used herein to describe devices that may be used in certain aspects of the present disclosure and should not be construed to limit the present disclosure to any particular device type unless the context otherwise requires. Thus, a device may include, without limitation, a bridge, router, bridge-router (brouter), switch, node, server, computer, appliance, or other type of device. Such devices typically include one or more network interfaces for communicating over a communication network and a processor (e.g., a microprocessor with memory and other peripherals and/or application-specific hardware) configured accordingly to perform device functions.

Communication networks generally may include public and/or private networks; may include local-area, wide-area, metropolitan-area, storage, and/or other types of networks; and may employ communication technologies including, but in no way limited to, analog technologies, digital technologies, optical technologies, wireless technologies (e.g., Bluetooth), networking technologies, and internetworking technologies.

It should also be noted that devices may use communication protocols and messages (e.g., messages created, transmitted, received, stored, and/or processed by the device), and such messages may be conveyed by a communication network or medium.

Unless the context otherwise requires, the present disclosure should not be construed as being limited to any particular communication message type, communication message format, or communication protocol. Thus, a communication message generally may include, without limitation, a frame, packet, datagram, user datagram, cell, or other type of communication message.

Unless the context requires otherwise, references to specific communication protocols are exemplary, and it should be understood that alternatives may, as appropriate, employ variations of such communication protocols (e.g., modifications or extensions of the protocol that may be made from time-to-time) or other protocols either known or developed in the future.

It should also be noted that logic flows may be described herein to demonstrate various aspects of the disclosure, and should not be construed to limit the present disclosure to any particular logic flow or logic implementation. The described logic may be partitioned into different logic blocks (e.g., programs, modules, functions, or subroutines) without changing the overall results or otherwise departing from the true scope of the disclosure.

Often, logic elements may be added, modified, omitted, performed in a different order, or implemented using different logic constructs (e.g., logic gates, looping primitives, conditional logic, and other logic constructs) without changing the overall results or otherwise departing from the scope of the disclosure.

The present disclosure may be embodied in many different forms, including, but in no way limited to, a graphical processing unit as well as computer program logic for use with a processor (e.g., a microprocessor, microcontroller, digital signal processor, or general purpose computer), programmable logic for use with a programmable logic device (e.g., a Field Programmable Gate Array (FPGA) or other PLD), discrete components, integrated circuitry (e.g., an Application Specific Integrated Circuit (ASIC)), or any other means including any combination thereof. Computer program logic implementing some or all of the described functionality is typically implemented as a set of computer program instructions that is converted into a computer executable form, stored as such in a computer readable medium, and executed by a microprocessor under the control of an operating system. Hardware-based logic implementing some or all of the described functionality may be implemented using one or more appropriately configured FPGAs.

Computer program logic implementing all or part of the functionality previously described herein may be embodied in various forms, including, but in no way limited to, a source code form, a computer executable form, and various intermediate forms (e.g., forms generated by an assembler, compiler, linker, or locator).

Source code may include a series of computer program instructions implemented in any of various programming languages (e.g., an object code, an assembly language, or a high-level language such as Fortran, python, C, C++, JAVA, JavaScript or HTML) for use with various operating systems or operating environments. The source code may define and use various data structures and communication messages. The source code may be in a computer executable form (e.g., via an interpreter), or the source code maybe converted (e.g., via a translator, assembler, or compiler) into a computer executable form.

Computer-executable program code for carrying out operations of embodiments of the present disclosure may be written in an object oriented, scripted or unscripted programming language such as Java, Perl, Smalltalk, C++, or the like. However, the computer program code for carrying out operations of aspects of the present disclosure may also be written in conventional procedural programming languages, such as the "C" programming language or similar programming languages.

Computer program logic implementing all or part of the functionality previously described herein may be executed at different times on a single processor (e.g., concurrently) or may be executed at the same or different times on multiple processors and may run under a single operating system process/thread or under different operating system processes/threads.

Thus, the term "computer process" refers generally to the execution of a set of computer program instructions regardless of whether different computer processes are executed on the same or different processors and regardless of whether different computer processes run under the same operating system process/thread or different operating system processes/threads.

The computer program may be fixed in any form (e.g., source code form, computer executable form, or an intermediate form) either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), a PC card (e.g., PCMCIA card), or other memory device.

The computer program may be fixed in any form in a signal that is transmittable to a computer using any of various communication technologies, including, but in no way limited to, analog technologies, digital technologies, optical technologies, wireless technologies (e.g., Bluetooth), networking technologies, and internetworking technologies.

The computer program may be distributed in any form as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web).

Hardware logic (including programmable logic for use with a programmable logic device) implementing all or part of the functionality previously described herein may be designed using traditional manual methods, or may be designed, captured, simulated, or documented electronically using various tools, such as Computer Aided Design (CAD), a hardware description language (e.g., VHDL or AHDL), or a PLD programming language (e.g., PALASM, ABEL, or CUPL).

Any suitable computer readable medium may be utilized. The computer readable medium may be, for example but not limited to, an electronic, magnetic, optical, electromagnetic, infrared, or semiconductor system, apparatus, device, or medium.

More specific examples of the computer readable medium include, but are not limited to, an electrical connection having one or more wires or other tangible storage medium such as a portable computer diskette, a hard disk, a random access memory (RAM), a read-only memory (ROM), an erasable programmable read-only memory (EPROM or Flash memory), a compact disc read-only memory (CD-ROM), or other optical or magnetic storage device.

Programmable logic may be fixed either permanently or transitorily in a tangible storage medium, such as a semiconductor memory device (e.g., a RAM, ROM, PROM, EEPROM, or Flash-Programmable RAM), a magnetic memory device (e.g., a diskette or fixed disk), an optical memory device (e.g., a CD-ROM), or other memory device.

The programmable logic may be fixed in a signal that is transmittable to a computer using any of various communication technologies, including, but in no way limited to, analog technologies, digital technologies, optical technologies, wireless technologies (e.g., Bluetooth), networking technologies, and internetworking technologies.

The programmable logic may be distributed as a removable storage medium with accompanying printed or electronic documentation (e.g., shrink wrapped software), preloaded with a computer system (e.g., on system ROM or fixed disk), or distributed from a server or electronic bulletin board over the communication system (e.g., the Internet or World Wide Web). Of course, some embodiments of the disclosure may be implemented as a combination of both software (e.g., a computer program product) and hardware. Still other aspects of the present disclosure are implemented as entirely hardware, or entirely software.

While certain exemplary aspects have been described and shown in the accompanying drawings, it is to be understood that such embodiments are merely illustrative of and are not restrictive on the broad disclosure, and that the aspects of the present disclosure are not limited to the specific constructions and arrangements shown and described, since various other changes, combinations, omissions, modifications and substitutions, in addition to those set forth in the above paragraphs, are possible.

Those skilled in the art will appreciate that various adaptations, modifications, and/or combination of the just described aspects and examples can be configured. Therefore, it is to be understood that, within the scope of the appended claims, the disclosure may be practiced other than as specifically described herein. For example, unless expressly stated otherwise, the steps of processes described herein may be performed in orders different from those described herein and one or more steps may be combined, split, or performed simultaneously. Those skilled in the art will also appreciate, in view of this disclosure, that different aspects or examples of the disclosure described herein may be combined to form other aspects or examples of the disclosure.

**Claims**

1. Method for determining the slip of a machine which comprises the steps of:

   - receiving a measurement signal, wherein the measurement signal includes a set of measurement values of an operational parameter of the machine,
   - determining the frequency spectrum of the measurement signal by converting the measurement signal into the frequency domain,
   - determining whether the frequency spectrum includes at least two peaks in the frequency spectrum for which different types of failure mode calculations return the same slip value,

   wherein, if in the determining step it is found that two peaks exist in the frequency spectrum which return the same slip value, said value is determined to be the slip value of the machine.

2. The method according to claim 1, wherein, for performing the failure mode calculations, equations for calculating a characteristic frequency of a failure mode are used.

3. The method according to claim 2, wherein the machine is a motor, and

a first equation used for the failure mode calculations is the characteristic frequency of a broken rotor bar of the machine, and a second equation is the characteristic frequency of an abnormal rotation of the machine.

4. The method according to at least one of the previous claims, wherein the failure mode calculations are performed by inserting the frequency value of a peak read from the frequency spectrum into the equation and by solving the equation for the value of the slip.

5. The method according to at least one of the previous claims, which includes a further step of reducing the number of peaks in the frequency spectrum before the determination step is performed, wherein the reducing of peaks is performed by omitting peaks which are not symmetric around the fundamental frequency peak of the machine.

6. The method according to claim 5, wherein peaks which relate to a folding frequency peaks are not omitted.

7. The method according to at least one of the previous claims, wherein the method includes a further step of reducing the frequency range to be searched for peaks by setting a predetermined range of slip values.

8. The method according to claim 7, wherein the predetermined range of slip values is set between 0 and 0.1.

9. The method according to at least one of the previous claims, wherein the operational parameter is a phase current of the machine measured over time.

10. The method according to at least one of claims 1 to 4 and 7 to 8, wherein the operational parameter is a torque current of the machine measured overtime.

11. The method according to at least one of the previous claims, wherein, if more than one pair of peaks is determined during the determination step, the slip value is determined to be the slip of the machine according to a predefined determination rule.

12. The method according to at least one of the previous claims, wherein the step of determination is carried out for the upper values of the characteristic frequency of the failure mode.

13. The method according to at least one of the previous claims, wherein, in addition or alternatively, the speed is output based on the determined slip value.

14. Device for performing the method of at least one of the previous method claims, having an input unit (101) for receiving a measurement signal, wherein the measurement signal includes a set of measurement values of an operational parameter of the machine, a computing unit (102) for performing the methods steps including determining the frequency spectrum of the measurement signal by converting the measurement signal into the frequency domain, and determining whether the frequency spectrum includes at least two peaks in the frequency spectrum for which different types of failure mode calculations return the same slip value, and an output unit (103) for outputting the determined slip value.

15. A computer program product having computer program logic arranged to put into effect the method according to at least one of claims 1 to 13, when being executed by a computer.

Fig. 1

Fig. 2

S1 — Read signal

S2 — Frequency spectrum

S3 — Find peaks and make list

S4a — Calculate slip for failure mode 1     S4b — Calculate slip for failure mode 2

S5 — Find possible pair

S6 — Show estimated slip (and possible peaks)

**Fig. 3**

Fig. 4

**Fig. 5**

Fig. 6

Fig. 7

EP 4 235 197 A1

```
S1 ─────┐
         │  ┌──────────────────────────────────────────────────────────┐
         └──│                        Read signal                        │
            └──────────────────────────────────────────────────────────┘
                                          │
                                          ▼
S2 ─────┐
         │  ┌──────────────────────────────────────────────────────────┐
         └──│                     Frequency spectrum                    │
            └──────────────────────────────────────────────────────────┘
                                          │
                                          ▼
S3 ─────┐
         │  ┌──────────────────────────────────────────────────────────┐
         └──│                    Find peaks and make list               │
            └──────────────────────────────────────────────────────────┘
                                          │
                                          ▼
S3a ────┐
         │  ┌──────────────────────────────────────────────────────────┐
         └──│            Append list taking care of folding frequency   │
            └──────────────────────────────────────────────────────────┘
                                          │
                                          ▼
S3b ────┐
         │  ┌──────────────────────────────────────────────────────────┐
         └──│       Reduce candidates based on symmetry and possible slip range  │
            └──────────────────────────────────────────────────────────┘
```

S4a                                                                S4b

| Calculate slip for failure mode 1 | Calculate slip for failure mode 2 |

```
S5 ─────┐
         │  ┌──────────────────────────────────────────────────────────┐
         └──│                      Find possible pair                   │
            └──────────────────────────────────────────────────────────┘
                                          │
                                          ▼
S6 ─────┐
         │  ┌──────────────────────────────────────────────────────────┐
         └──│             Show estimated slip (and possible peaks)      │
            └──────────────────────────────────────────────────────────┘
```

**Fig. 8**

**Fig. 9**

EP 4 235 197 A1

Fig. 10

**Europäisches Patentamt**
**European Patent Office**
**Office européen des brevets**

# EUROPEAN SEARCH REPORT

Application Number

EP 22 15 8578

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 049 815 A (KLIMAN GERALD B [US]) 17 September 1991 (1991-09-17) | 1,4-6, 9-15 | INV. G01R31/34 |
| Y | * Col. 2, Line3-37; Col. 4, Line 8-38; Col. 5, Line 16 – Col. 7, Line 10; figure 1 * | 2,3,7,8 | ADD. G01R23/18 |
| Y | US 2016/282416 A1 (CHOI SEUNGDEOG [US]) 29 September 2016 (2016-09-29) * paragraph [0036] * | 2,3 | |
| Y | US 6 087 796 A (CANADA RONALD G [US] ET AL) 11 July 2000 (2000-07-11) * column 5, line 11 – line 13 * | 7,8 | |

TECHNICAL FIELDS SEARCHED (IPC)

G01R

The present search report has been drawn up for all claims

| Place of search | Date of completion of the search | Examiner |
|---|---|---|
| The Hague | 31 August 2022 | Mazagão Guerreiro, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 8578

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2022

| Patent document cited in search report | Publication date | Patent family member(s) | Publication date |
|---|---|---|---|
| US 5049815 A | 17-09-1991 | NONE | |
| US 2016282416 A1 | 29-09-2016 | NONE | |
| US 6087796 A | 11-07-2000 | NONE | |

EPO FORM P0459

For more details about this annex : see Official Journal of the European Patent Office, No. 12/82